# EUROPEAN PATENT APPLICATION

(11) **EP 2 031 605 A1**
(43) Date of publication of application: **04.03.2009**
(21) Application number: 07742091.7
(22) Date of filing: 20.04.2007
(51) Int. Cl.: H01B 12/06, H01B 13/00

(54) **SUPERCONDUCTING THIN FILM MATERIAL AND METHOD FOR PRODUCING SUPERCONDUCTING THIN FILM MATERIAL**

(30) Priority: 18.05.2006 JP 2006139262
(71) Applicant: Sumitomo Electric Industries, Ltd., Osaka-shi, Osaka 541-0041 (JP)
(72) Inventor: HAHAKURA, Shuji, Osaka-shi Osaka 554-0024 (JP); OHMATSU, Kazuya, Osaka-shi Osaka 554-0024 (JP)
(74) Representative: Kreutzer, Ulrich
(86) International application number: PCT/JP2007/058656
(87) International publication number: WO 2007/135831

(57) **Abstract**

A superconductive thin film material which achieves good superconductivity by preventing an element diffusion reaction and a manufacturing method of the superconductive thin film material are provided. A superconductive thin film material (10) is provided with a substrate (11), an intermediate layer (12) with one layer or at least two layers formed on the substrate (11), and a superconductive layer (13) formed on the intermediate layer (12). The intermediate layer (12) has a thickness of not less than 0.4 µm. The material for forming the intermediate layer (12) is preferably oxide having a crystal structure, which is at least one of a halite type, a fluorite type, a perovskite type, and a pyrochlore type.

## Description

### TECHNICAL FIELD

The present invention relates to a superconductive thin film material and a manufacturing method of the superconductive thin film material, and for example to a superconductive thin film material which is superior in superconductivity and a manufacturing method of the superconductive thin film material.

### BACKGROUND ART

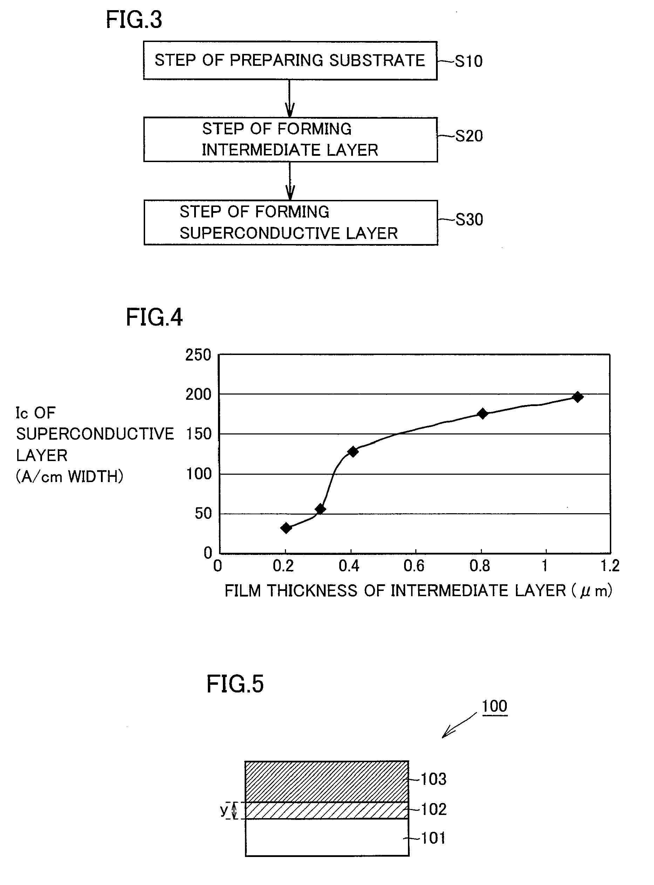

Conventionally, as shown in Fig. 5, a superconductive thin film material is formed of an intermediate layer 102 laminated on a substrate 101 and a superconductive layer 103 further deposited on intermediate layer 102. In order for such a superconductive thin film material 100 to obtain good superconductivity, for example Japanese Patent Laying Open No. 11-53967 (Patent Document 1) discloses an oriented polycrystalline base material with an oriented polycrystalline intermediate layer. Note that Fig. 5 is a cross sectional view showing a conventional superconductive thin film material.

Above-mentioned Patent Document 1 discloses a method in which an intermediate layer is formed on a substrate with a crystal orientation on its surface, followed by a superconductive layer further formed thereon, in order to improve the orientation of the superconductive layer.
Patent Document 1: Japanese Patent Laying Open No. 11-53967

### DISCLOSURE OF THE INVENTION

### PROBLEMS TO BE SOLVED BY THE INVENTION

However, with the oriented polycrystalline base material disclosed in above-mentioned Patent Document 1, an element diffusion reaction may occur, i.e., constituent elements of the superconductive layer may diffuse out to the substrate side while constituent elements of the substrate may diffuse out to the superconductive layer side, because the superconductive layer is deposited by utilizing a thermal reaction. When the constituent elements of the substrate reach the superconductive layer beyond the intermediate layer, they tend to react with the superconducting elements of which the superconductive layer is composed, leading to a problem of lower superconductivity.

Hence the present invention was made to solve the above problem, and an object of the present invention is to provide a superconductive thin film material achieving superior superconductivity by preventing the element diffusion reaction and a manufacturing method of such a superconductive thin film material.

### MEANS FOR SOLVING THE PROBLEMS

The inventors found out that the thickness of the intermediate layer accounts for the problem of developing the element diffusion reaction in the superconductive thin film material. The constituent elements of the substrate reach the superconductive layer beyond the intermediate layer to cause the problem of the element diffusion reaction therebetween if the intermediate layer has an insufficient thickness. The inventors have worked out wholeheartedly to prevent such an element diffusion reaction and consequently found out the film thickness of the intermediate layer required to prevent the element diffusion reaction.

The superconductive thin film material according to the present invention is provided with a substrate, an intermediate layer, and a superconductive layer. One or at least two layers constitute the intermediate layer, formed on the substrate, with a thickness of not less than 0.4 µm. The superconductive layer is formed on the intermediate layer.

According to the superconductive thin film material of the present invention, the element diffusion between the substrate and the superconductive layer can be prevented by providing the intermediate layer of not less than 0.4 µm in thickness. Thus the degradation of superconductivity of the formed superconductive layer can be prevented, making it possible to provide the superconductive thin film material with good superconductivity.

A material for forming the intermediate layer in the above-mentioned superconductive thin film material is preferably an oxide having a crystal structure which is at least one of a halite type, a fluorite type, a perovskite type, and a pyrochlore type.

These material for the intermediate layer tend to develop less element diffusion reactions with the superconductive layer, even if the intermediate layer is in contact with the superconductive layer, because they have very low reactivity with a superconductive layer.

Preferably, the material for forming the substrate in the above-mentioned superconductive thin film material is an oriented metal while the material for forming the intermediate layer includes at least one of yttria-stabilized zirconia, cerium oxide, magnesium oxide, and strontium titanate.

Thus the element diffusion reaction between the substrate and the superconductive layer can be suppressed when an oriented metal with excellent property is used for a substrate.

A manufacturing method of a superconductive thin film material according to the present invention is directed to a method of manufacturing the above-mentioned superconductive thin film including the steps of preparing a substrate, forming an intermediate layer constituted of one layer or at least two layers on the substrate, and forming a superconductive layer. In the step of forming the superconductive layer, the superconductive layer is formed on the intermediate layer by at least one of vapor and liquid deposition methods.

According to the manufacturing method of the superconductive thin film material of the present invention, the superconductive layer with its surface being excellent in the crystal orientation as well as smoothness can be formed in the step of forming the superconductive layer. Therefore, the superconductive thin film material with good superconductivity showing a large critical current value and large critical current density can be manufactured.

### EFFECTS OF THE INVENTION

According to the superconductive thin film material of the present invention, providing an intermediate layer of not less than 0.4 µmin thickness, which is sufficient to prevent an element diffusion reaction, achieves superior superconductivity.

### BRIEF DESCRIPTION OF THE DRAWINGS

Fig. 1 is a cross sectional view showing the superconductive thin film material according to an embodiment of the invention.
Fig. 2 is a cross sectional view showing another example of the superconductive thin film material according to an embodiment of the invention.
Fig. 3 is a flow chart for describing the manufacturing method of the superconductive thin film material according to an embodiment of the invention.
Fig. 4 shows a critical current value for the superconductive thin film material according to an example of the invention.
Fig. 5 is a cross sectional view showing a conventional superconductive thin film material.

### DESCRIPTION OF THE REFERENCE SIGNS

10 superconductive thin film material, 11 substrate, 12 intermediate layer, 12a first layer, 12b second layer, 12c third layer, 13 superconductive layer.

### BEST MODES FOR CARRYING OUT THE INVENTION

An embodiment of the present invention will be described hereinafter with reference to the drawings. The same or corresponding elements have the same reference characters allotted. Their label and function are also identical. Therefore, detailed description thereof will not be repeated.

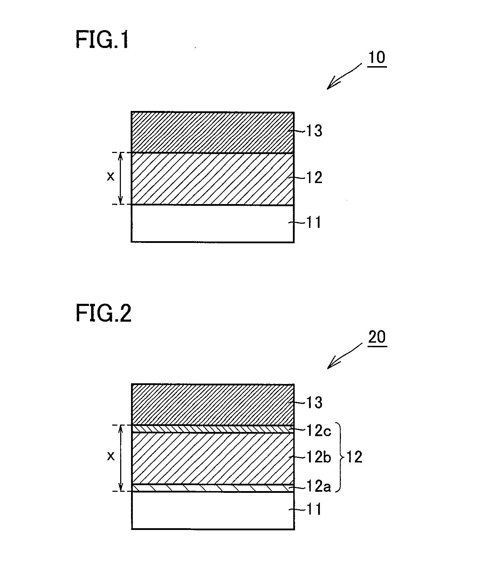

Fig. 1 is a cross sectional view showing the superconductive thin film material according to an embodiment of the present invention. With reference to Fig. 1, the superconductive thin film material according to the embodiment of the present invention is now described.

As shown in Fig. 1, a superconductive thin film material 10 according to this embodiment is provided with a substrate 11, an intermediate layer 12 constituted of one layer or at least two layers and formed on substrate 11, and a superconductive layer 13 formed on intermediate layer 12. Intermediate layer 12 has a thickness of not less than 0.4 µm.

More specifically, the material forming substrate 11 is preferably metal. More preferably, substrate 11 is an oriented metal substrate. Note that an oriented metal substrate means a substrate in which the crystal orientation is uniform with respect to biaxial directions within the plane on the substrate surface. An alloy which is composed of two or more metals among the following, for example, may be suitably used as an oriented metal substrate: Ni (nickel), Cr (chromium), Mn (manganese), Co (cobalt), Fe (iron), Pd (palladium), Cu (copper), Ag (silver) and Au (gold). Such metals can also be laminated with other metals or alloys. For example alloys such as SUS, which is a high-strength material, can also be used. Note that the material of substrate 11 is not particularly limited to the above and materials other than metal, for example, may be used as well.

Substrate 11 may be 50 - 200 µm thick and have a lengthy belt-like shape.

A thickness x of intermediate layer 12 is not less than 0.4 µm. Thickness x is preferably not less than 0.8 µm, more preferably not less than 1.1 µm. If a thickness y of intermediate layer 102 is as small as in the conventional superconductive thin film material 100 shown in Fig. 5, the element diffusion reaction may occur, i.e., the constituent elements of substrate 101 move towards superconductive layer 103 and the constituent elements of superconductive layer 103 move towards substrate 101. The inventors found out that intermediate layer 12 should have a thickness of not less than 0.4 µm in order to prevent the element diffusion reaction. That is, the element diffusion reaction can be prevented by setting thickness x of intermediate layer 12 to not less than 0.4 µm and good superconductivity can be achieved as a result. By setting thickness x to not less than 0.8 µm, the element diffusion reaction can be further prevented and the element diffusion reaction can be still further prevented by setting thickness x to not less than 1.1 µm.

The material for forming intermediate layer 12 is preferably an oxide having a crystal structure which is at least one of a halite type, a fluorite type, a perovskite type, and a pyrochlore type. Examples of the oxide that has such a crystal structure include: rare earth element oxides such as cerium oxide (CeO₂), holmium oxide (Ho₂O₃), yttrium oxide (Y₂O₃), and ytterbium oxide (Yb₂O₃); yttria-stabilized zirconia (YSZ); magnesium oxide (MgO); strontium titanate (SrTiO₃); BZO (BaZrO₃); aluminum oxide (Al₂O₃); and Ln-M-O compound (Ln is one or more lanthanoid elements, M is one or more element chosen from Sr, Zr, and Ga, and O is oxygen). In particular, yttria-stabilized zirconia (YSZ), cerium oxide (CeO₂) magnesium oxide (MgO), strontium titanate (SrTiO₃) and the like may be suitably used as a material for forming intermediate layer 12 from a viewpoint of the crystal constant and crystal orientation. These materials have very low reactivity with superconductive layer 13 such that they do not degrade superconductivity of superconductive layer 13 even at the interface at which the intermediate layer 12 with these materials contacts with superconductive layer 13. In particular, in the case where metal is used as a material for forming substrate 11, the difference between substrate 11 which has a crystal orientation on its surface and superconductive layer 13 is reduced and the metal atoms are prevented from outflowing from substrate 11, which is composed of oriented metal with a crystal orientation on its surface, to superconductive layer 13, when superconductive layer 13 is formed at a high temperature. Note that the material for forming intermediate layer 12 is not limited to the above-mentioned material.

Moreover, intermediate layer 12 has preferably a good crystal orientation. The above-mentioned materials are examples of such materials which have a good crystal orientation.

Intermediate layer 12 may be constituted of a plurality of layers as shown in Fig. 2. In such a case where a plurality of layers constitute intermediate layer 12, the total thickness of each layer serves as thickness x of intermediate layer 12, which should also be not less than 0.4 µm. Note that Fig. 2 is a cross sectional view showing another example of the superconductive thin film material according to an embodiment of the present invention.

When intermediate layer 12 is constituted of a plurality of layers, each layer constituting intermediate layer 12 may be formed from different materials. For example as shown in Fig. 2, intermediate layer 12 can be of three layers, a first layer 12a, a second layer 12b and a third layer 12c. Preferably, in this case, first layer 12a is formed on substrate 11 as a seed crystal layer serving as a core of the crystal growth. Second layer 12b is preferably formed on first layer 12a as a diffusion preventing layer preventing the element diffusion reaction. Third layer 12c is preferably formed as a lattice matching layer to match the lattice size with that of superconductive layer 13 which is formed thereon. Note that cerium oxide for example can be suitably used for the seed crystal layer. Yttria-stabilized zirconia for example is suitably used for the diffusion preventing layer. Cerium oxide for example is suitably used for the lattice matching layer.

Intermediate layer 12 is not particularly limited as above, but may be of any number of layers, for example two, not less than four, or one layer as shown in Fig. 1. Where one layer or two layers constitute(s) the intermediate layer, it is preferable that the layer(s) serve(s) as the seed crystal layer, the diffusion preventing layer, and the lattice matching layer.

Note that the lattice mismatching rate between intermediate layer 12 and superconductive layer 13 is preferably not more than 10%, and the lattice mismatching rate between intermediate layer 12 and substrate 11 is not more than 10%.

It is preferred that the surface of intermediate layer 12 on which superconductive layer 13 is formed is flat. For example, intermediate layer 12 has preferably surface roughness of 10nm or less.

Although the material for forming superconductive layer 13 is not particularly limited, it is preferable to use for example an RE-123 superconductor. Note that the RE-123 superconductor refers to a superconductor expressed as REBa₂Cu₃Oy (y is between 6 and 8, more preferably approximately 7, RE is a rare earth element such as yttrium, Gd, Sm, or Ho). Thus forming intermediate layer 12 and superconductive layer 13 on substrate 11, which is composed of a flexible metal, can achieve the superconductive thin film material which shows a large critical current value and critical current density. The thickness of superconductive layer 13 may be for example between 0.2 µm and 5 µm.

When using the superconductive thin film material for example as a superconducting wire material, Ag (silver) stabilized layer or Cu (copper) stabilized layer may be formed on superconductive layer 13 as a surface protecting layer or a stabilized layer (not shown) in order to protect the surface of superconductive layer 13.

Now with reference to Figs. 1 and 3, the manufacturing method of the superconductive thin film material according to the embodiment of the present invention is described. Note that Fig. 3 is a flow chart for explaining the manufacturing method of the superconductive thin film material according to the embodiment of the present invention.

As shown in Fig. 3, a step of preparing substrate 11 (S10) is initially performed. In this step (S10), substrate 11 serving as a base for superconductive thin film material 10 is prepared. Preferably the material for substrate 11 may be an oriented metal material, such as a belt-like metal tape made for example of nickel.

Subsequently, a step of forming intermediate layer 12 (S20) is performed. At this step (S20), intermediate layer 12 is formed on prepared substrate 11 so that its thickness is not less than 0.4 µm. The oxide which has a crystal structure such as a halite type, fluorite type, perovskite type and pyrochlore type, for example, can be used as intermediate layer 12. At the step (S20), any deposition method such as a physical deposition method including a pulsed laser deposition method (PLD method) and the like, can be used.

Note that at the step (S20), first layer 12a is formed on substrate 11 for example by the physical deposition method, second layer 12b is formed on first layer 12a for example by the physical deposition method, and third layer 12c is formed on second layer 12b for example by the physical deposition method, in the same way as described above, even when intermediate layer 12 is constituted of multiple layers as shown in Fig. 2.

Next, a step of forming superconductive layer 13 on the surface of intermediate layer 12 is performed (S30). At this step (S30), superconductive layer 13 is formed by either vapor or liquid deposition method.

Specifically, the laser deposition method, the sputtering method, the electron beam deposition method and the like may be mentioned, for example, as the vapor deposition method. The organic metal deposition method and the like, for example, are mentioned as the liquid deposition method. If superconductive layer 13 is formed by at least one of the laser deposition method, the sputtering method, the electron beam method, and organic metal deposition method, the layer can be provided with the surface with the superior crystal orientation as well as smoothness.

In the step (S30), in forming superconductive layer 13, a temperature from 600 °C to 900 °C is preferably set. Even when superconductive layer 13 is thus formed under such a high temperature, the atomic diffusion reaction is hardly generated between superconductive layer 13 and substrate 11, because intermediate layer 12 is sufficiently thick.

Note that a planarization step of planarizing the surfaces of substrate 11, intermediate layer 12 and superconductive layer 13 may be performed following steps (S10, 20, 30). The planarization step can be carried out by any method such as CMP (Chemical Mechanical Polishing) method, wet etching method, mechanical polishing method, and the like.

Superconductive thin film material 10 can be manufactured by carrying out steps (S10-S30) described above.

Moreover, when using the superconductive thin film material as a superconducting wire material, for example, another step of forming a surface protecting layer (not shown) on the surface of superconductive layer 13 may be further provided. At this step, for example, a surface protecting layer, which is an Ag stabilized layer, is formed on superconductive layer 13.

Superconductive thin film material 10 according to the embodiment of the present invention prevents the element diffusion reaction in which the constituent elements of substrate 11 move towards superconductive layer 13 and the constituent elements of superconductive layer 13 move towards substrate 11, because intermediate layer 12 has a thickness of not less than 0.4 µm, as described above. Moreover, superconductive thin film material 10 according to the embodiment serves to provide a good crystal orientation as well as to prevent the element diffusion reaction. Thus, superconductive thin film material 10 can achieve excellent superconductivity because the property of superconductive layer 13 is not degraded.

### [Example 1]

The following experiments were conducted in order to confirm the effect of the superconductive thin film material according to the present invention. That is, the superconductive thin film materials with the intermediate layer of thickness shown in Table 1 according to examples 1-3 and comparative examples 1 and 2 were prepared and their critical current values were measured. The film thickness of the intermediate layer of each superconductive thin film material and the measured value of the critical current are shown in Table 1.

**[Table 1]**

| | THICKNESS OF INTERMEDIATE LAYER (µm) | CRITICAL CURRENT VALUE (A/cm WIDTH) |
|---|---|---|
| EXAMPLE 1 | 0.4 | 128 |
| EXAMPLE 2 | 0.8 | 175 |
| EXAMPLE 3 | 1.1 | 197 |
| COMPARATIVE EXAMPLE 1 | 0.2 | 32 |
| COMPARATIVE EXAMPLE 2 | 0.3 | 55 |

### (Example 1: Superconductive thin film material)

In example 1, the superconductive thin film material was manufactured basically according to the manufacturing method of the above-mentioned embodiment. Specifically, a Ni alloy substrate was first prepared at the step of preparing a substrate (S10). Then at the step of forming an intermediate layer (S20), the intermediate layer composed of metal oxide was formed on the substrate by the vapor deposition method. Specifically, the intermediate layer was constituted of three layers and cerium oxide was formed to a thickness of 0.1 µm as a seed crystal layer (a first layer) for growing crystals on the substrate. Then YSZ was formed to a thickness of 0.2 µm as a diffusion preventing layer (a second layer) on the seed crystal layer, and cerium oxide was formed to a thickness of 0.1 µm as a lattice matching layer (a third layer). Then at the step of forming a superconductive layer (S30), HoBa₂Cu₃Oₓ (HoBCO) was deposited as a superconductive layer by the laser deposition method so that it has a film thickness of 0.8 µm. The superconductive thin film material according to example 1 was thus obtained.

Note that the film thickness of the intermediate layer in Table 1 shows the total thickness of the first, second and third layers.

### (Example 2: Superconductive thin film material)

The superconductive thin film material in example 2 was basically provided with the same structure as in example 1 except that the intermediate layer in example 2 had a film thickness of 0.8 µm. Specifically, the intermediate layer of the superconductive thin film material in example 2 had the seed crystal layer (first layer) of 0.1 µm thick, the diffusion preventing layer (second layer) of 0.6 µm thick, and the lattice matching layer (third layer) of 0.1 µm thick.

### (Example 3: Superconductive thin film material)

The superconductive thin film material in example 3 was basically provided with the same structure as in example 1 except that the intermediate layer in example 3 had a film thickness of 1.1 µm. Specifically, the intermediate layer of the superconductive thin film material in example 3 had the seed crystal layer (first layer) of 0.1 µm thick, the diffusion preventing layer (second layer) of 0.9 µm thick, and the lattice matching layer (third layer) of 0.1 µm thick.

### (Comparative example 1: Superconductive thin film material)

The superconductive thin film material in comparative example 1 was basically provided with the same structure as in example 1 except that the thickness of the intermediate layer in comparative example 1 had a film thickness of 0.2 µm. Specifically, the intermediate layer of the superconductive thin film material in comparative example 1 had the seed crystal layer (first layer) of 0.1 µm thick, the diffusion preventing layer (second layer) of 0 µm thick and the lattice matching layer (third layer) of 0.1 µm thick.

### (Comparative example 2: Superconductive thin film material)

The superconductive thin film material in comparative example 2 was basically provided with the same structure as in example 1 except that the intermediate layer in comparative example 2 had a film thickness of 0.3 µm. Specifically, the intermediate layer of the superconductive thin film material in comparative example 2 had the seed crystal layer (first layer) of 0.1 µm thick, the diffusion preventing layer (second layer) of 0.1 µm thick and the lattice matching layer (third layer) of 0.1 µm thick.

### (Measurement result)

The results of measurement, as described above, of the critical current values for the superconductive thin film material in examples 1-3 and comparative examples 1 and 2 are presented in Fig. 4. In Fig. 4, the horizontal axis shows the film thickness of the intermediate layer (unit: µm) and the vertical axis shows the critical current value (unit: A / cm width) of the superconductive layer.

As shown in Table 1 and in Fig. 4, the critical current value of the superconductive thin film material in examples 1-3 where the film thickness of the intermediate layer is 0.4 µm or above was not less than 128A / cm width, proving superior superconductivity. On the other hand, the critical current value in comparative examples 1 and 2 was low because of the element diffusion reaction between the superconductive layer and the substrate, because the superconductive thin film material in comparative examples 1 and 2 had the intermediate layer which was less than 0.4 µm in thickness.

According to the examples of the present invention, it was found that the superconductive thin film material of the present invention could improve the superconductive layer properties such as the critical current value by making the intermediate layer not less than 0.4 µm in thickness.

The embodiments and examples disclosed herein should not be taken by way of limitation but illustrative in all respects. It is intended that the scope of the present invention be expressed by the terms of the appended claims, rather than by the above-mentioned description, and all the modifications within the meaning and scope of the claims and their equivalents be included.

## Claims

1. A superconductive thin film material (10, 20) comprising:
a substrate (11);
an intermediate layer (12), constituted of one layer or at least two layers, formed on said substrate; and
a superconductive layer (13) formed on said intermediate layer (12),
said intermediate layer (12) having a thickness of not less than 0.4 µm.

2. The superconductive thin film material (10, 20) according to claim 1, wherein
a material for forming said intermediate layer (12) is an oxide having a crystal structure which is at least one of a halite type, a fluorite type, a perovskite type, and a pyrochlore type.

3. The superconductive thin film material (10, 20) according to claim 1, wherein
a material for forming said substrate (11) is an oriented metal, and
a material for forming said intermediate layer (12) includes at least one of yttria-stabilized zirconia, cerium oxide, magnesium oxide, and strontium titanate.

4. A method of manufacturing the superconductive thin film material (10, 20) according to claim 1, comprising the steps of:
preparing said substrate (11) (S10);
forming intermediate layer (12) constituted of one layer or at least two layers and having a thickness of not less than 0.4 µm on said substrate (11) (S20); and
forming said superconductive layer (13) on said intermediate layer (12) by at least one of vapor and liquid deposition methods (S30).
